# FASCICULE DE BREVET EUROPEEN

(11) **EP 2 093 797 B1**
(45) Date de publication et mention de la délivrance du brevet: **31.05.2017**
(21) Numéro de dépôt: 09354005.2
(22) Date de dépôt: 10.02.2009
(51) Int. Cl.: B81C 3/00, H01L 23/64, H01L 25/065, H01L 25/00

(54) **Procédé d'alignement de deux substrats par des microbobines**
Ausrichtungsverfahren von zwei Substraten mit Hilfe von Mikrospulen
Method for aligning two substrates by microcoils

(30) Priorité: 22.02.2008 FR 0800957
(43) Date de publication de la demande: 26.08.2009
(73) Titulaire: Commissariat à l'Énergie Atomique et aux Énergies Alternatives, 75015 Paris (FR)
(72) Inventeur: Rousseau, Maxime, 38000 Grenoble (FR); Viala, Bernard, 38360 Sassenage (FR)
(74) Mandataire: Hecké, Gérard

(56) Documents cités:
- EP-A- 0 439 136
- DE-A1-102006 001 601
- US-A1- 2002 110 936

## Description

### Domaine technique de l'invention

L'invention est relative à un procédé d'alignement entre des premier et second substrats, ayant des faces en regard comportant des moyens de détection de l'alignement, procédé comportant, dans une phase d'alignement, le déplacement des substrats l'un par rapport à l'autre dans un plan parallèle aux substrats, la mesure d'une grandeur électrique associée aux moyens de détection de l'alignement et la détermination de l'alignement en fonction des variations de ladite grandeur.

### État de la technique

L'intégration tridimensionnelle représente un nouveau schéma d'intégration dans lequel plusieurs niveaux de composants actifs sont empilés les uns sur les autres et forment ainsi une puce multi-niveaux. D'un point de vue pratique, l'intégration tridimensionnelle consiste à reporter face-à-face deux substrats ayant des circuits intégrés complémentaires et à les coller pour ne former qu'une seule puce. Cependant, le principal problème est lié à l'alignement des deux circuits intégrés de manière à ce que les composants actifs de chacun des substrats puissent communiquer.

Pour réaliser ce type d'intégration, les techniques d'alignement « substrat sur substrat », principalement utilisées dans le domaine des microsystèmes, par exemple pour les microsystèmes électromécaniques, offrent de nombreux avantages.

Cependant, pour réaliser une intégration de type tridimensionnelle qui couple deux circuits intégrés ayant une forte densité en composants actifs, par exemple des transistors CMOS, il est nécessaire de posséder un système d'alignement de haute précision.

Majoritairement, l'alignement de deux substrats est réalisé par des techniques optiques. De manière générale, des marques d'alignement sont formées sur chacun des substrats. Une tête de lecture optique détermine alors sur chacun des substrats les coordonnées des marques. L'alignement des substrats est alors réalisé en alignant les marques entre elles. De façon conventionnelle, un désalignement de l'ordre de 1µm est obtenu dans des conditions optimales de réalisation, ce qui limite l'intérêt de l'intégration tridimensionnelle, notamment en terme de densité d'intégration des interconnexions inter-niveaux.

Une méthode capacitive a été développée, notamment dans le brevet US 7193423, pour remplacer la technique optique et atteindre de meilleures précisions d'alignement. Une structure de couplage capacitif est alors intégrée sur chacun des substrats, juste en dessous d'une couche d'oxyde servant au collage moléculaire. Les deux substrats sont ensuite mis en contact direct et un condensateur, constitué par les structures de couplages capacitifs des deux substrats séparés par l'oxyde de silicium, est alors formé. Le déplacement des substrats l'un par rapport à l'autre se traduit alors par une variation de la valeur de la capacité du condensateur qui peut alors être utilisée pour réaliser l'alignement. Une variation de capacité d'au moins 10⁻¹⁸F doit être obtenue pour un déplacement d'un nanomètre.

De nombreux inconvénients réduisent fortement l'intérêt de cette technique. En effet, la formation du condensateur implique que les deux couches d'oxyde de silicium soient en contact direct. En pratique, une interface de collage moléculaire est déjà formée, engendrant la création de liaisons faibles et le déplacement des substrats l'un par rapport à l'autre dans la phase d'alignement risque d'entraîner la formation de défauts dans l'interface de collage, ce qui diminue la fiabilité du collage et du circuit obtenu. De plus, l'alignement des substrats est lié à la mesure de la valeur de la capacité, elle-même dépendante de la distance qui sépare les deux électrodes du condensateur. Si l'épaisseur de la couche d'oxyde varie, la valeur de la capacité varie également. Ainsi, si la couche d'oxyde ne présente pas une épaisseur constante, il est difficile de réaliser un alignement fiable et utilisable industriellement.

Le document EP-A-439136 décrit un procédé de connexion électrique et d'encapsulation d'un dispositif semi-conducteur au moyen de la détection du passage d'un courant électrique.

### Objet de l'invention

L'invention a pour objet un procédé d'alignement de deux substrats qui soit facile à mettre en oeuvre, qui présente une grande précision d'alignement et qui soit compatible avec les procédés de fabrication conventionnels.

Le procédé selon l'invention est caractérisé en ce que les moyens de détection de l'alignement comportent des microbobines au niveau des faces en regard des premier et second substrats, et en ce que le procédé comporte au moins l'alimentation des microbobines du premier substrat et la mesure de l'inductance des microbobines du second substrat, ladite inductance constituant ladite grandeur électrique.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de façon schématique, en coupe, deux substrats en regard comportant chacun des moyens de mesure de l'alignement selon l'invention,
- la figure 2 illustre une disposition particulière des microbobines,
- les figures 3 à 5 représentent, de façon schématique, en vue de dessus, des exemples de réalisation de microbobines,
- la figure 6 représente, de façon schématique, le sens du courant et les lignes de champ résultant correspondant à une coupe selon l'axe X d'une microbobine selon la figure 5,
- les figures 7 et 8 représentent, de façon schématique, respectivement 5 positions de désalignement de deux microbobines en regard et la mesure de la variation d'inductance correspondante.

### Description d'un mode de réalisation préférentiel de l'invention

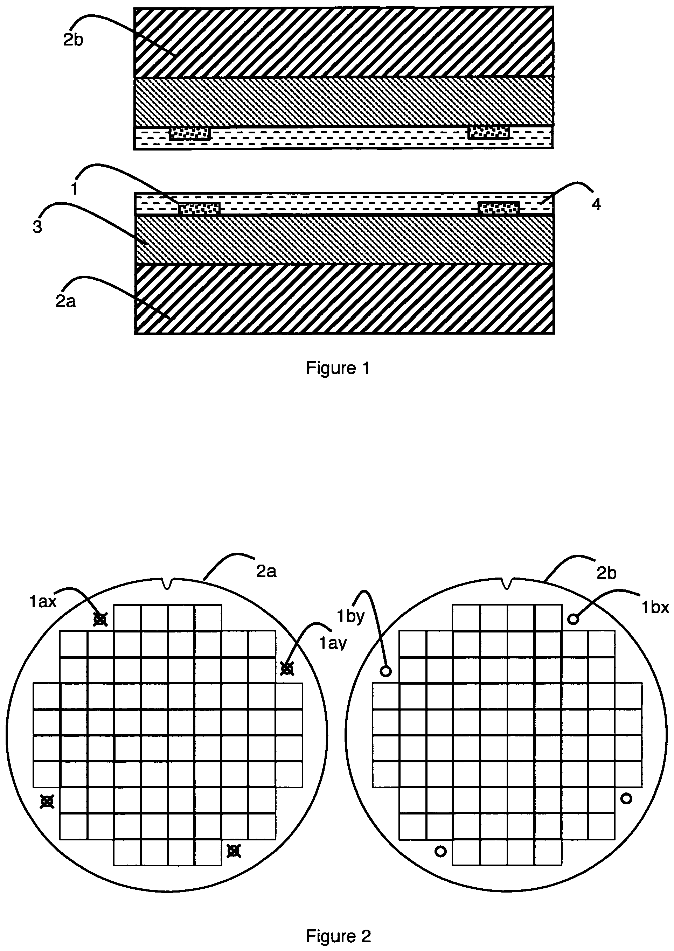

Selon l'invention, les moyens de détection de l'alignement 1 sont de type inductif et formés au niveau des faces en regard des substrats 2 à aligner, comme illustré très schématiquement à la figure 1. Chaque substrat 2 peut comporter des composants actifs, par exemple des transistors, des niveaux d'interconnexion métallique 3 connectant les différents composants actifs entre eux. Les moyens de détection de l'alignement de type inductif sont constitués par des microbobines 1, de type solénoïde ou plane. Les microbobines 1 de type solénoïde étant plus compliquées à réaliser et coûteuses, les microbobines 1 planes leurs sont préférées.

Les microbobines 1 sont avantageusement formées dans les niveaux d'interconnexion métallique et, de préférence, dans le dernier niveau d'interconnexion métallique, le niveau le plus éloigné du substrat 2. Les microbobines 1 sont réalisées après la fabrication des niveaux d'interconnexion métallique 3. Elles sont, de préférence, recouvertes par une couche en matériau diélectrique 4, par exemple en matériau polymère , en matériau minéral, en nitrure de silicium, ou avantageusement en oxyde de silicium, destinée au collage moléculaire. La couche 4 a typiquement une épaisseur de l'ordre de 200 nm une fois aplanie.

Comme illustré à la figure 2, les microbobines 1 sont, de préférence, disposées à la périphérie du substrat 2. Elles sont connectées à des plots de contact électriques (non représentés) par l'intermédiaire de lignes de connexion. Les plots de contact permettent d'alimenter les microbobines 1 et/ou de mesurer leur inductance globale par l'intermédiaire d'un circuit de traitement extérieur (non représenté).

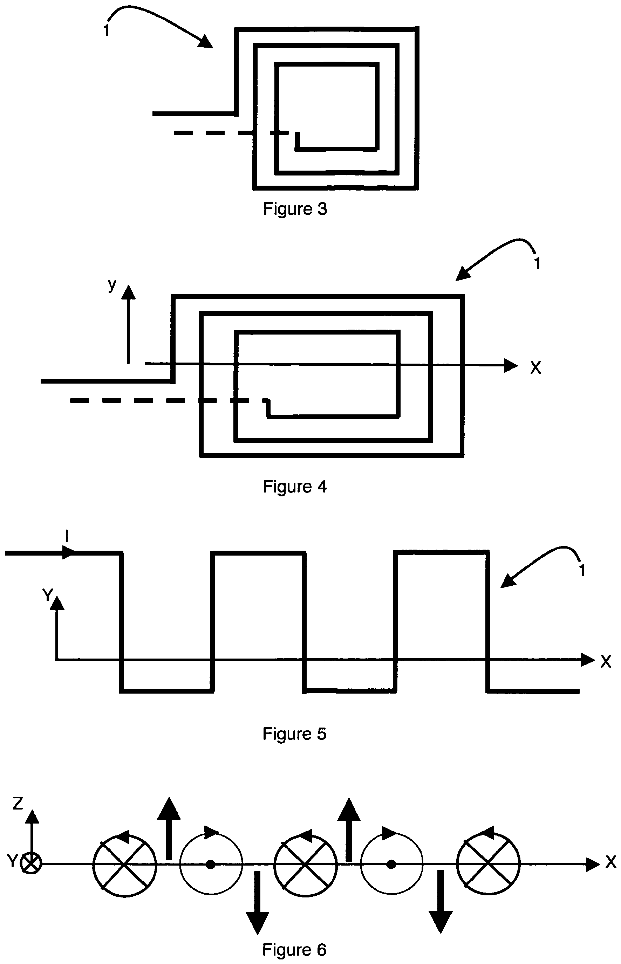

Comme illustré aux figures 3 à 5, différents types de microbobines 1 planes sont utilisables. Les microbobines planes peuvent, par exemple, être des microbobines en forme de spirale, carrée (figure 3) ou allongée (figure 4). De telles microbobines 1 planes en spirale carrée sont couramment utilisées dans le domaine des microsystèmes et de la microélectronique. La réalisation de microbobines 1 en forme de spirale carrée (figure 3) est très bien maîtrisée. Elle est formée sur le dernier niveau d'interconnexion métallique. Cependant, une des lignes de connexion (en pointillé sur la figure 3) est réalisée sur un niveau d'interconnexion inférieur. La conception doit être intégrée sur deux niveaux de métal consécutifs. Les dimensions de ce type de bobine sont dépendantes du nombre de spires qui la constituent. Ce type de bobine a des lignes de champ assez dispersives, qui fournissent un champ d'interaction assez étendu par rapport au diamètre interne de la microbobine 1. En conséquence, la précision obtenue pour l'alignement est limitée et peut être insuffisante.

Un alignement plus précis peut être obtenu suivant une direction perpendiculaire à la direction d'élongation d'une microbobine 1 plane en spirale allongée (figure 4), c'est-à-dire suivant un axe (Y) perpendiculaire à l'axe principal de la bobine (axe X sur la figure 4), de forme rectangulaire. Pour obtenir un alignement satisfaisant des deux substrats 2, l'alignement est, de préférence, réalisé en deux étapes successives. Un premier alignement est réalisé selon un axe Y avec des microbobines ayant un axe principal selon X. Puis, un alignement est réalisé selon X avec des microbobines perpendiculaires aux précédentes, c'est-à-dire d'axe principal selon Y. Pour des microbobines planes en spirale allongée, le déplacement et l'alignement d'un substrat 2 par rapport à l'autre sont donc réalisés successivement selon des axes perpendiculaires aux axes principaux des microbobines 1.

Un autre type de microbobine 1 plane en forme de méandre, illustrée à la figure 5, est avantageusement utilisée. Ces microbobines ne sont plus en forme de spirale mais en forme de serpentin. Les lignes de champ induites par ce type de bobine ont la particularité de ne pas se reboucler sur elles-mêmes, mais d'interagir selon une seule direction, à savoir l'axe principal de la microbobine, c'est-à-dire selon la direction X sur la figure 5. Ce type de microbobine 1 permet d'obtenir une meilleure précision que celle obtenue avec des bobines en spirale. Comme précédemment, pour une précision optimale, des microbobines 1 planes en méandre sont orientées suivant deux directions, de préférence, perpendiculaires et l'alignement est réalisé en deux étapes successives. Cependant, pour des microbobines en forme de méandre, le déplacement et l'alignement d'un substrat 2 par rapport à l'autre sont réalisés successivement selon des axes parallèles aux axes principaux des microbobines 1.

L'avantage majeur des bobines planes à méandre est de présenter un mode de réalisation beaucoup plus simple d'un point de vue technologique que les bobines solénoïdales, et même que les bobines planes à spirale carrée ou allongée. En effet, dans le cas des bobines à méandre, seul un niveau de métal est nécessaire à la fabrication contre deux niveaux pour les spirales carrées et beaucoup plus pour les solénoïdes. Au moment de la conception des circuits, il suffit juste de réserver un emplacement pour les microbobines et leur réalisation se fait en même temps que le dernier niveau de métal du circuit. De plus, les matériaux utilisés dans les microbobines sont des matériaux classiques de la microélectronique. Les microbobines sont donc fabriquées en cuivre et sont isolées par un diélectrique conventionnel, ce qui élimine des problèmes de compatibilité des matériaux et des surcoûts éventuels.

Avantageusement, chaque substrat comporte au moins deux microbobines 1 planes avec des axes principaux orientés suivant des directions différentes. Encore plus avantageusement, chaque substrat comporte deux séries de microbobines, chaque microbobine d'une série ayant son axe principal orienté suivant une même direction prédéfinie, les directions des deux séries n'étant pas parallèles. Bien que l'alignement soit plus simple lorsque les axes principaux des différentes séries de microbobines 1 sont perpendiculaires, il est envisageable d'utiliser des axes principaux non perpendiculaires. L'alignement des deux substrats 2, l'un par rapport à l'autre, dans un plan parallèle aux substrats, est alors réalisé. Cet alignement peut être effectué directement ou avantageusement en deux temps. Un premier déplacement et un premier alignement sont réalisés avec une première série de microbobines 1 orientées suivant un premier axe principal. Ensuite, une seconde série de microbobines 1 allongées suivant un second axe principal est utilisée pour réaliser un second déplacement des substrats entre eux. L'utilisation de premier et second déplacement dissociés est particulièrement avantageux pour finaliser l'alignement des substrats si les axes principaux sont perpendiculaires. En effet, l'alignement suivant le second axe ne modifie pas l'alignement déjà réalisé suivant le premier axe principal. De cette manière, en déplaçant les substrats 2, l'un par rapport à l'autre, suivant des directions parallèles aux axes principaux des microbobines, il est possible d'aligner les substrats avec une très grande précision. De cette manière, les spécificités morphologiques de chacune des bobines permettent de réduire successivement les désalignements des substrats 2 suivant deux directions.

De manière générale, les microbobines 1 sont disposées sur les surfaces des substrats 2a et 2b de manière à ce que deux microbobines présentant des axes principaux sensiblement parallèles soient en regard lors de l'alignement. Dans un mode de réalisation préférentiel, illustré à la figure 2, les microbobines 1 sont disposées à la périphérie des substrats 2. Avantageusement, au moins deux microbobines 1 x ou 1 y présentant la même direction principale sont disposées symétriquement par rapport au centre du substrat. Sur la figure 2, deux séries de microbobines 1 x et 1 y sont chacune constituées par deux microbobines disposées symétriquement par rapport au centre de chacun des substrats 2a et 2b et à leur périphérie. Cette disposition des microbobines est particulièrement avantageuse pour augmenter la précision de l'alignement. De cette manière, lorsque les surfaces des substrats 2a et 2b, comportant les microbobines, sont mises en regard, les microbobines 1 ax, respectivement 1 ay, sont sensiblement en regard des microbobines 1 bx, respectivement 1 by. Le procédé d'alignement peut alors être initié.

Les microbobines 1 sont classiquement réalisées dans le dernier niveau d'interconnexion métallique sous la forme de lignes de cuivre ayant une section typique de l'ordre de 100x100nm². L'espacement minimal entre deux lignes de cuivre est de l'ordre de 100nm. Typiquement, les microbobines ont des dimensions maximales de quelques microns, par exemple 5x5µm² avec un espacement interspire de l'ordre de 5 µm. La surface occupée par une microbobine 1 est typiquement inférieure à 900µm². De manière classique, le nombre de spires des microbobines 1 est au minimum de deux et préférentiellement égale à cinq. Typiquement, les microbobines étant réalisées dans le dernier niveau d'interconnexion métallique, leur épaisseur est prédéfinie. Cependant, si l'épaisseur est incompatible avec les performances inductives nécessaire, un niveau supplémentaire spécifique peut être réalisé pour la formation des microbobines.

Dans un premier mode de réalisation du procédé d'alignement, seules les microbobines 1 de l'un des substrats 2 sont alimentées par un courant alternatif. L'alignement des substrats est alors réalisé en mesurant la variation d'inductance dans les microbobines 1 de l'autre substrat, qui ne sont pas alimentées. Une variation d'inductance autour d'une valeur nulle est mesurée puisque ces microbobines ne sont pas alimentées.

Dans un second mode de réalisation, les microbobines 1 des deux substrats 2 sont alimentées par deux courants alternatifs, préférentiellement de même fréquence, avec un déphasage nul et de même amplitude. Les microbobines 1 sont alimentées de manière à ce que les courants qui traversent les deux microbobines soient dirigés dans le même sens. Ainsi, les lignes de champ induit par chacune des bobines sont dirigées dans le même sens. Une interaction optimale est alors obtenue quand les deux microbobines 1 sont parfaitement alignées, c'est-à-dire quand les deux substrats sont parfaitement alignés.

Lors du passage d'un courant dans une microbobine 1, des lignes de champ induit sont créées autour du fil métallique formant la bobine. L'orientation des lignes de champ est fonction du sens du courant qui traverse la microbobine 1. La figure 6 illustre le sens du courant, selon la direction y, les lignes de champ induit d'une microbobine 1 en forme de méandre selon la figure 4 vue en coupe selon l'axe X. Les méandres de la microbobine font que le courant I a des sens opposés dans deux portions adjacentes perpendiculaires à l'axe X. En conséquence, dans une microbobine en forme de méandre, les lignes de champ induit ont des sens de rotation opposés et sont alternativement réparties. Il en résulte alors que les forces résultantes de l'interaction de ces lignes de champs, représentées sur la figure 6 par des flèches parallèles à l'axe Z, sont également opposées et alternativement réparties.

Dans tous les cas, les microbobines 1 de l'un des substrats, par exemple le substrat inférieur 2a, sont connectées à des moyens de détection de l'inductance, par exemple à un multimètre. Le multimètre mesure l'inductance induite dans la microbobine du substrat inférieur 2a, par la microbobine correspondante du substrat supérieur 2b. La valeur de la variation de l'inductance induite dans la microbobine inférieure par la microbobine supérieure est utilisée directement pour localiser la position des substrats entre eux. Le multimètre est classiquement connecté à un circuit de traitement (non représenté) qui contrôle des moyens de micro-positionnement. Le processus d'alignement repose sur le fait que le couplage inductif est maximal lorsque les deux microbobines associées sont parfaitement en regard, c'est-à-dire sont alignées sur un même axe vertical.

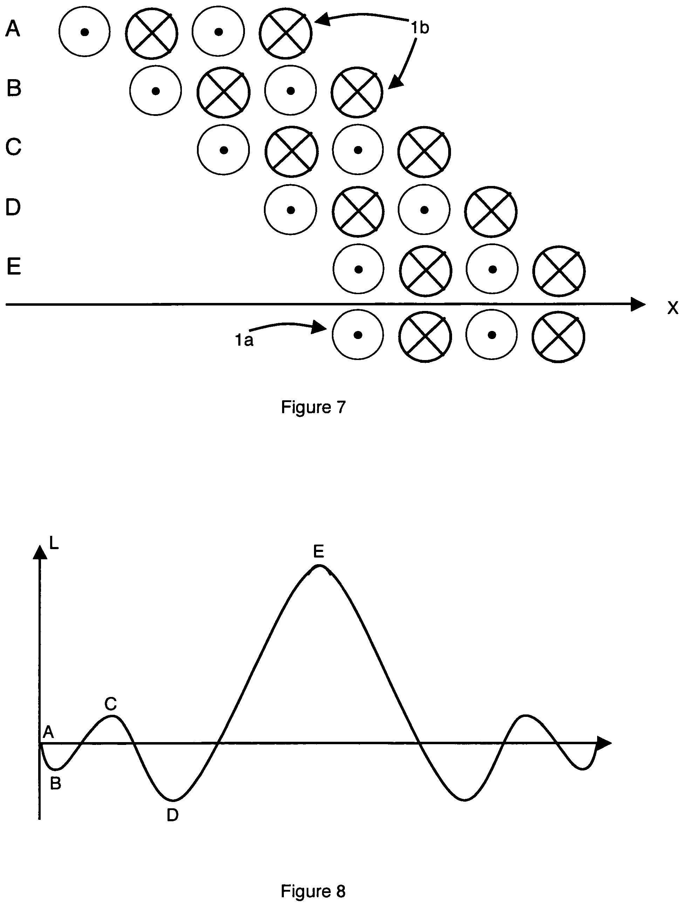

Dans le mode de réalisation particulier illustré aux figures 6 et 7 deux microbobines 1 identiques, en forme de méandre, sont associées et les deux microbobines sont alimentées de manière à ce que les courants qui traversent les deux microbobines soient dirigés dans le même sens. Une seule microbobine, constituant la microbobine de mesure, est utilisée pour mesurer la variation d'inductance ΔL. Les deux microbobines étant identiques, leurs champs induits le sont également si les intensités traversant les deux circuits inductifs sont égales. De cette manière, les forces résultantes de chacune des bobines sont identiques dans leur intensité et leur position par rapport aux spires. Les figures 6 et 7 illustrent différentes positions de deux microbobines l'une par rapport à l'autre et la variation de l'inductance ΔL de la microbobine de mesure qui découle des différentes interactions des forces résultantes. Sur la figure 7, la microbobine de mesure 1 a, à la partie inférieure de la figure, ne bouge pas, tandis que la microbobine 1 b associée est déplacée selon l'axe X et prend 5 positions différentes. Les différentes positions illustrées vont, selon l'axe X, d'un désalignement total (position A) à un alignement (position E) complet des deux microbobines 1.

Dans la position A, les deux microbobines 1 a et 1 b ne se recouvrent pas du tout. Il n'y a alors aucune variation de l'inductance L dans la microbobine de mesure 1 a puisque le système n'est pas perturbé. En réduisant leur désalignement, l'inductance de la microbobine de mesure varie. Les lignes de champ induit dans les branches en regard (branche la plus à droite de la microbobine 1 b en déplacement et branche la plus à gauche de la microbobine de mesure 1 a) étant de sens opposés, la variation d'inductance est tout d'abord négative. Lorsque les deux microbobines arrivent dans la position B, dans laquelle les microbobines ont une seule ligne de champ en regard, de sens opposés, cette ligne de champ s'annule et l'inductance globale mesurée aux bornes de la microbobine de mesure atteint un premier minimum. En poursuivant le déplacement vers la droite de la microbobine 1 b, l'inductance augmente car l'interaction entre les lignes de champ induit de sens opposés diminue et est progressivement remplacée par une interaction entre des lignes de champ de même sens.

Dans la position C, les microbobines 1 a et 1 b ont deux lignes de champ en regard, qui sont orientées dans le même sens. Le système de couplage se renforce au lieu de s'annuler. Dans la position C, la variation d'inductance L atteint un premier maximum, plus important, en valeur absolue, que la variation maximum atteinte dans la position B car deux couples de lignes de champ sont alors en interaction au lieu d'un seul couple.

Dans la position D, comme dans la position B, la variation d'inductance correspond à la mise en regard de lignes de champs opposées. Cependant, dans la position D, trois lignes de champs sont mises en jeu et l'inductance atteint un minimum plus élevé, en valeur absolue, que le minimum atteint dans la position B ou que le maximum atteint dans la position C. Dans la position E, dans laquelle les deux microbobines 1a et 1 b sont parfaitement alignées selon l'axe X, toutes les lignes de champs sont en regard et dans le même sens, ce qui se traduit par une variation positive maximum de l'inductance. Le processus d'alignement repose ici sur le fait que tous les champs induits issus des microbobines 1 a et 1 b interagissent de manière contructive et non destructive lorsque la position E est réalisée.

Il est ainsi possible de déterminer l'alignement maximal des microbobines. Lorsque l'alignement des microbobines est maximal, l'amplitude de la variation de l'inductance est également maximale ce qui correspond à un désalignement minimal entre les substrats. L'amplitude de la variation de l'inductance dans la microbobine de mesure est indépendant du sens du courant qui traverse les microbobines et ne dépend que de l'alignement entre les microbobines.

A titre d'exemple, on peut détecter une variation d'inductance de 5%, c'est-à-dire comprise entre 0,025 et 0,1 nH pour des microbobines planes en forme de méandre ayant une inductance initiale comprise entre 0,5 et 2nH.

Contrairement à la méthode capacitive, l'alignement par la méthode inductive peut être réalisé sans contact direct entre les substrats. En effet, la variation d'inductance est détectable à distance ce qui signifie que l'alignement peut être effectué en laissant un intervalle prédéterminé entre les substrats pendant la phase d'alignement. De cette manière, la génération de défauts à l'interface de collage est nulle puisqu'il n'y a pas de contact entre les deux substrats. Par ailleurs, la distance séparant les deux substrats est typiquement comprise dans la gamme de quelques microns à quelques dizaines de microns, ce qui permet de relâcher les contraintes sur un système de contrôle de la distance de séparation. A titre d'exemple, la distance typique est de 10µm pour des bobines mettant en jeu des dimensions micrométriques (typiquement entre 1 et 5µm) et des courants de quelques dizaines de milliampères, par exemple 50mA.

## Revendications

1. Procédé d'alignement entre des premier et second substrats (2), les substrats (2) ayant des faces en regard comportant des moyens de détection de l'alignement (1), procédé comportant, dans une phase d'alignement, le déplacement des substrats (2) l'un par rapport à l'autre dans un plan parallèle aux substrats (2), la mesure d'une grandeur électrique associée aux moyens de détection de l'alignement et la détermination de l'alignement en fonction des variations de ladite grandeur, procédé **caractérisé en ce que** les moyens de détection de l'alignement comportent des microbobines (1) au niveau des faces en regard des premier et second substrats (2), et **en ce que** le procédé comporte au moins l'alimentation des microbobines (1) du premier substrat (2) et la mesure de l'inductance des microbobines (1) du second substrat (2), ladite inductance constituant ladite grandeur électrique.

2. Procédé selon la revendication 1, **caractérisé en ce que** l'alignement des substrats (1) est maximal quand la variation de l'inductance mesurée est maximale.

3. Procédé selon l'une des revendications 1 et 2, **caractérisé en ce qu'**il comporte l'alimentation des microbobines (1) des deux substrats (2).

4. Procédé selon l'une quelconque des revendications 1 à 3, **caractérisé en ce que** les deux substrats (2) sont séparés par un intervalle prédéterminé pendant la phase d'alignement.

5. Procédé selon l'une quelconque des revendications 1 à 4, **caractérisé en ce que** les microbobines (1) sont constituées par des microbobines planes.

6. Procédé selon la revendication 5, **caractérisé en ce que** les microbobines (1) sont de type spirale carrée ou spirale allongée.

7. Procédé selon la revendication 5, **caractérisé en ce que** les microbobines (1) sont de type microbobines en méandre.

8. Procédé selon l'une quelconque des revendications 1 à 7, **caractérisé en ce que** des microbobines (1) comportant un axe principal, chaque substrat (2) comporte au moins deux séries de microbobines (1) ayant des axes principaux d'orientations différentes, chaque série comportant au moins deux microbobines disposées symétriquement par rapport au centre du substrat (2).

9. Procédé selon la revendication 8, **caractérisé en ce que** les microbobines étant de type spirale allongée, le déplacement et l'alignement d'un substrat (2) par rapport à l'autre sont réalisés successivement selon des axes perpendiculaires aux axes principaux desdites microbobines (1).

10. Procédé selon la revendication 8, **caractérisé en ce que** les microbobines étant en forme de méandre, le déplacement et l'alignement d'un substrat (2) par rapport à l'autre sont réalisés successivement selon des axes parallèles aux axes principaux desdites microbobines (1).

11. Procédé selon l'une quelconques des revendications 8 à 10, **caractérisé en ce que** les axes principaux sont perpendiculaires.

12. Procédé selon l'une quelconque des revendications 1 à 11, **caractérisé en ce que** les substrats (2) comportant des niveaux d'interconnexion métallique, les microbobines (1) sont réalisées dans le dernier niveau d'interconnexion métallique.

## Patentansprüche

1. Verfahren zur Ausrichtung zwischen einem ersten und einem zweiten Substrat (2), wobei die Substrate (2) gegenüberliegende Seiten aufweisen, die Mittel zur Erfassung der Ausrichtung (1) umfassen, Verfahren, das in einer Ausrichtungsphase die Bewegung der Substrate (2) zueinander in einer zu den Substraten (2) parallelen Ebene, die Messung einer den Mitteln zur Erfassung der Ausrichtung zugeordneten elektrischen Größe sowie die Bestimmung der Ausrichtung in Abhängigkeit von den Änderungen der Größe umfasst, Verfahren, **dadurch gekennzeichnet, dass** die Mittel zur Erfassung der Ausrichtung Mikrospulen (1) im Bereich der gegenüberliegenden Seiten des ersten und des zweiten Substrats (2) umfassen und dass das Verfahren wenigstens die Versorgung der Mikrospulen (1) des ersten Substrats (2) und die Messung der Induktivität der Mikrospulen (1) des zweiten Substrats (2) umfasst, wobei die Induktivität die elektrische Größe darstellt.

2. Verfahren nach Anspruch 1, **dadurch gekennzeichnet, dass** die Ausrichtung der Substrate (2) maximal ist, wenn die Änderung der gemessenen Induktivität maximal ist.

3. Verfahren nach einem der Ansprüche 1 und 2, **dadurch gekennzeichnet, dass** es die Versorgung der Mikrospulen (1) der beiden Substrate (2) umfasst.

4. Verfahren nach einem der Ansprüche 1 bis 3, **dadurch gekennzeichnet, dass** die beiden Substrate (2) während der Ausrichtungsphase durch einen vorbestimmten Abstand getrennt sind.

5. Verfahren nach einem der Ansprüche 1 bis 4, **dadurch gekennzeichnet, dass** die Mikrospulen (1) durch flache Mikrospulen gebildet sind.

6. Verfahren nach Anspruch 5, **dadurch gekennzeichnet, dass** die Mikrospulen (1) vom Typ quadratische Spirale oder langgestreckte Spirale sind.

7. Verfahren nach Anspruch 5, **dadurch gekennzeichnet, dass** die Mikrospulen (1) vom Typ mäanderförmige Mikrospulen sind.

8. Verfahren nach einem der Ansprüche 1 bis 7, **dadurch gekennzeichnet, dass** wenn Mikrospulen (1) eine Hauptachse umfassen, jedes Substrat (2) wenigstens zwei Reihen von Mikrospulen (1) mit Hauptachsen unterschiedlicher Ausrichtungen umfasst, wobei eine jede Reihe wenigstens zwei Mikrospulen umfasst, die in Bezug auf den Mittelpunkt des Substrats (2) symmetrisch angeordnet sind.

9. Verfahren nach Anspruch 8, **dadurch gekennzeichnet, dass** wenn die Mikrospulen vom Typ langgestreckte Spirale sind, die Bewegung und die Ausrichtung eines Substrats (2) in Bezug auf das andere nacheinander entlang von zu den Hauptachsen der Mikrospulen (1) senkrechten Achsen vollzogen werden.

10. Verfahren nach Anspruch 8, **dadurch gekennzeichnet, dass** wenn die Mikrospulen mäanderförmig sind, die Bewegung und die Ausrichtung eines Substrats (2) in Bezug auf das andere nacheinander entlang von zu den Hauptachsen der Mikrospulen (1) parallelen Achsen vollzogen werden.

11. Verfahren nach einem der Ansprüche 1 bis 10, **dadurch gekennzeichnet, dass** die Hauptachsen senkrecht verlaufen.

12. Verfahren nach einem der Ansprüche 1 bis 11, **dadurch gekennzeichnet, dass** wenn die Substrate (2) Ebenen metallischer Verbindung umfassen, die Mikrospulen (1) in der letzten Ebene metallischer Verbindung ausgebildet sind.

## Claims

1. An alignment method between first and second substrates (2), the substrates (2) having facing surfaces comprising alignment detection means (1), a method comprising, in an alignment phase, displacement of the substrates (2) with respect to one another in a plane parallel to the substrates (2), the measure of an electrical quantity associated with the alignment detection means and determination of the alignment according to the variations of said quantity, a method **characterized in that** the alignment detection means comprise microcoils (1) at the level of facing surfaces of first and second substrates (2), and **in that** the method comprises at least the power supply of microcoils (1) of the first substrate (2), and the measuring of the inductance of the microcolis (1) of the second substrate (2), the said inductance constituting the said electrical quantity.

2. The method according to claim 1, **characterized in that** the alignment of the substrates (1) is maximal when the measured inductance variation is maximal.

3. The method according to any of claims 1 and 2, **characterized in that** it comprises power supply of the microcoils (1) of the two substrates (2).

4. The method according to any one of claims 1 to 3, **characterized in that** the two substrates (2) are separated by a predetermined gap during the alignment phase.

5. The method according to any one of claims 1 to 4, **characterized in that** the microcoils (1) are formed by flat microcoils.

6. The method according to claim 5, **characterized in that** the microcoils (1) are of square spiral or elongate spiral type.

7. The method according to claim 5, **characterized in that** the microcoils (1) are of serpentine type.

8. The method according to any one of claims 1 to 7, **characterized in that** the microcoils (1) comprising a main axis, each substrate (2) comprises at least two series of microcoils (1) having main axes of different orientations, each series comprising at least two microcoils arranged symmetrically with respect to the center of the substrate (2).

9. The method according to claim 8, **characterized in that** the microcoils being of elongate spiral type, movement and alignment of one substrate (2) with respect to the other are performed successively along axes perpendicular to the main axes of said microcoils (1).

10. The method according to claim 8, **characterized in that** the microcoils being in the form of a serpentine, movement and alignment of one substrate (2) with respect to the other are performed successively along axes parallel to the main axes of said microcoils (1).

11. The method according to any one of claims 8 to 10, **characterized in that** the main axes are perpendicular.

12. The method according to any one of claims 1 to 11, **characterized in that** the substrates (2) comprising metallic interconnection levels, the microcoils (1) are made in the last metallic interconnection level.
